(19) Europäisches Patentamt
European Patent Office
Office européen des brevets

(11) **EP 4 576 583 A1**

(12) **DEMANDE DE BREVET EUROPEEN**

(43) Date de publication:
**25.06.2025 Bulletin 2025/26**

(21) Numéro de dépôt: **24218047.9**

(22) Date de dépôt: **06.12.2024**

(51) Classification Internationale des Brevets (IPC):
**H03M 7/40** *(2006.01)*  **H03M 7/30** *(2006.01)*

(52) Classification Coopérative des Brevets (CPC):
**H03M 7/4006; H03M 7/6005; H03M 7/6023**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **19.12.2023 FR 2314483**

(71) Demandeur: **STMicroelectronics International N.V.**
**1228 Plan-les-Ouates, Geneva (CH)**

(72) Inventeur: **XUE, Min**
**38170 Seyssinet Pariset (FR)**

(74) Mandataire: **Casalonga**
**Casalonga & Partners**
**Bayerstraße 71/73**
**80335 München (DE)**

(54) **SYSTÈME INFORMATIQUE ET PROCÉDÉ DE DÉCODAGE ARITHMÉTIQUE**

(57) Selon un aspect, il est proposé un système informatique comprenant :
- une mémoire (MEM) de données configurée pour stocker un tableau de coefficients (CUM_FREQ2_TAB[]),
- un processeur de traitement du signal numérique(DSP1, DSP2) configurée pour exécuter un programme d'ordinateur (PRG1, PRG2) comprenant des instructions permettant de réaliser un décodage arithmétique à partir dudit tableau de coefficients et d'un intervalle de valeurs,
- un circuit (HWC1, HWC2) dédié audit décodage arithmétique, ce circuit étant configuré pour :

• effectuer des comparaisons à partir des coefficients dudit tableau de coefficients et dudit intervalle de valeurs, puis
• compter les résultats desdites comparaisons qui sont identiques et successifs,

le processeur de traitement du signal numérique (DSP1, DSP2) étant configurée pour déterminer une valeur d'un symbole associé audit tableau de coefficients à partir du nombre desdits résultats identiques et successifs compté par ledit circuit dédié.

FIG.1

EP 4 576 583 A1

**Description**

Des modes de réalisation et de mise en oeuvre concernent le décodage arithmétique.

Le codage arithmétique est une technique de compression de données couramment utilisée en informatique et en traitement du signal. Contrairement au codage binaire traditionnel, où chaque symbole est représenté par un nombre fixe de bits, le codage arithmétique permet de représenter des symboles en utilisant des fractions d'intervalles de nombres réels.

Le codage arithmétique présente l'avantage de pouvoir compresser efficacement des données en fonction de la probabilité des symboles. Les symboles les plus fréquents occuperont des fractions plus petites de l'intervalle, tandis que les symboles moins fréquents occuperont des fractions plus grandes, permettant ainsi une compression plus efficace des données.

Le codage arithmétique est notamment utilisé par le codeur-décodeur audio « LC3 » (de l'anglais « Low Complexity Communication Codec »). Le codage arithmétique est alors utilisé pour compresser des données audios puis le décodage arithmétique pour restaurer les données audio originales à partir de la représentation compressée.

En particulier, le codage arithmétique met en oeuvre différentes étapes. Dans un premier temps, des probabilités sont affectés aux symboles. En particulier, avant de commencer le codage, chaque symbole dans le message est associé à une probabilité. Les probabilités peuvent être basées sur des statistiques de fréquence d'apparition des symboles dans le message.

Ensuite, un intervalle initial est défini au début du processus de codage. Puis le message est parcouru symbole par symbole. À chaque étape, l'intervalle actuel est divisé en sous-intervalles, dont la taille est proportionnelle aux probabilités des symboles. Le sous-intervalle correspondant au symbole en cours de traitement est sélectionné pour représenter ce symbole. L'intervalle actuel devient alors le sous-intervalle sélectionné.

Une fois que tous les symboles ont été codés, la représentation binaire du nombre réel se trouvant dans l'intervalle final est extraite. Cette représentation binaire est le message compressé.

Une fois le message compressé par le codage arithmétique, il est possible de récupérer le message initial en procédant à un décodage arithmétique inversant les étapes mises en oeuvre lors du codage arithmétique.

En particulier, le décodage arithmétique comprend une initialisation de l'intervalle initial utilisé lors du codage à partir des probabilités associées aux symboles.

Une fois que l'intervalle initial est reconstruit, le décodage itératif des symboles peut commencer. Le décodeur commence à lire les bits de la représentation binaire du message compressé un par un, et à chaque étape, il réajuste l'intervalle en fonction de la séquence de bits lue. Il doit tenir compte des probabilités associées aux symboles pour déterminer quel sous-intervalle correspond au symbole en cours de décodage.

À chaque itération, le décodeur compare l'intervalle actuel avec les sous-intervalles correspondant à chaque symbole possible. Lorsqu'un sous-intervalle correspond à l'intervalle actuel, le décodeur identifie le symbole associé à ce sous-intervalle comme le symbole décodé.

Plus particulièrement, à chaque itération, une comparaison est réalisée en la valeur de début d'intervalle et une valeur calculée par une multiplication entre la longueur de l'intervalle et un coefficient. Chaque coefficient correspond à une valeur associée à un symbole. La séquence de tests est effectuée jusqu'à obtenir un résultat de comparaison correspondant à une condition de validité de test. Pour décoder un symbole, le nombre de tests effectués est une valeur comprise entre 1 et le nombre de symboles possibles.

Les méthodes connues pour réaliser un décodage arithmétique requièrent d'effectuer des branchements à chaque itération. Ces nombreux branchements augmentent le temps nécessaire pour effectuer le décodage arithmétique. Ainsi, un tel décodage arithmétique est peu efficace.

Il existe donc un besoin de proposer une solution permettant de réaliser un décodage arithmétique de manière plus rapide.

Selon un aspect, il est proposé un système informatique comprenant :

- une mémoire de données configurée pour stocker un tableau de coefficients,
- un processeur de traitement du signal numérique configuré pour exécuter un programme d'ordinateur comprenant des instructions permettant de réaliser un décodage arithmétique à partir dudit tableau de coefficients et d'un intervalle de valeurs,
- un circuit dédié audit décodage arithmétique, ce circuit étant configuré pour :

  • effectuer des comparaisons à partir des coefficients dudit tableau de coefficients et dudit intervalle de valeurs, puis
  • compter les résultats desdites comparaisons qui sont identiques et successifs,

le processeur de traitement du signal numérique étant configuré pour déterminer une valeur d'un symbole associé audit tableau de coefficients à partir du nombre desdits résultats identiques et successifs compté par ledit circuit dédié.

L'utilisation d'un circuit dédié au décodage arithmétique intégré dans ledit processeur de traitement du signal numérique permet d'accélérer le décodage arithmétique, en réduisant le nombre de cycles dudit processeur de traitement du signal numérique pour réaliser le décodage arithmétique. De la sorte, cela permet également de réduire la consommation d'énergie pour effectuer un décodage arithmétique. En outre, le fait d'effectuer dans un premier temps l'ensemble des comparaisons associées à chacun des coefficients du tableau avant de calculer la valeur du symbole permet d'éviter d'effectuer de nombreux branchements par rapport aux solutions connues.

Dans un mode de réalisation avantageux, le circuit dédié comprend un premier bloc configuré pour calculer une variable de comparaisons permettant de stocker les résultats desdites comparaison, le résultat de chaque comparaison correspondant à un bit de la variable de comparaisons.

De préférence, le premier bloc est configuré pour réaliser en parallèle au moins deux comparaisons à partir d'au moins deux coefficients successifs du tableau de coefficients avec l'intervalle de valeurs.

Ainsi, dans un tel système informatique, le fait d'effectuer dans un premier temps l'ensemble des comparaisons associées à chacun des coefficients du tableau avant de calculer la valeur du symbole permet une parallélisation des comparaisons. Cela permet donc d'accélérer le décodage arithmétique.

Avantageusement, le premier bloc comprend au moins deux branches parallèles permettant d'effectuer simultanément lesdites deux comparaisons, chaque branche comportant :

- un circuit multiplieur configuré pour effectuer une multiplication entre un coefficient parmi lesdits deux coefficients successifs et une longueur dudit intervalle de valeurs décalée d'un nombre donné de bits, ce nombre donné de bits étant notamment compris entre 0 et un nombre de bits utilisés pour définir la longueur dudit intervalle (par exemple ledit nombre donné de bits est égal à 10),
- un circuit de comparaison configuré pour comparer un résultat de la multiplication à une valeur de début de l'intervalle de valeurs.

Dans un mode de réalisation avantageux, le premier bloc comprend en outre un circuit de mise à jour de la variable de comparaisons configuré pour intégrer dans ladite variable de comparaisons les résultats de la comparaison effectuée par chaque circuit de comparaison.

De préférence, le circuit dédié comprend également un deuxième bloc configuré pour mettre en oeuvre une machine d'état configuré pour compter les résultats identiques successifs stockés dans ladite variable de comparaisons en analysant les bits de ladite variable de comparaisons.

Avantageusement, les résultats de chaque comparaison effectuée par le premier bloc sont stockés progressivement à droite dans la variable de comparaisons. La machine d'état mise en oeuvre par le deuxième bloc est alors configurée pour compter le nombre de résultats de comparaison identiques à partir des bits situés les plus à droite dans la variable de comparaisons.

En variante, les résultats de chaque comparaison effectuée par le premier bloc sont stockés progressivement à gauche dans la variable de comparaisons. La machine d'état mise en oeuvre par le deuxième bloc est alors configurée pour compter le nombre de résultats de comparaison identiques à partir des bits situés les plus à gauche dans la variable de comparaisons.

Dans un mode de réalisation avantageux, ledit programme d'ordinateur comprend des instructions qui lorsqu'elles sont exécutées par le processeur de traitement du signal numérique conduisent celle-ci à :

- mettre en oeuvre le premier bloc afin d'effectuer en parallèle une comparaison à partir de chaque coefficient dudit tableau de coefficient avec ledit intervalle, le résultat de chaque comparaison étant stocké dans la variable de comparaison, puis
- mettre en oeuvre le deuxième bloc, une fois l'ensemble des comparaisons effectuées, pour compter les résultats identiques successifs stockés dans ladite variable de comparaisons en analysant les bits de ladite variable de comparaisons, puis
- calculer une valeur du symbole associé audit tableau de coefficients à partir du nombre de résultats identiques successifs compté.

Selon un autre aspect, il est proposé un procédé mis en oeuvre par un système informatique, le procédé comprenant une exécution, par un processeur de traitement du signal numérique du système informatique, d'un programme d'ordinateur comprenant des instructions permettant de réaliser un décodage arithmétique à partir d'un tableau de coefficients stocké dans une mémoire de données du système informatique et d'un intervalle de valeurs, le décodage arithmétique comportant :

- une mise en oeuvre d'un circuit du système informatique dédié audit décodage arithmétique pour :

  - effectuer des comparaisons à partir des coefficients dudit tableau de coefficients et dudit intervalle de valeurs, puis
  - compter les résultats desdites comparaisons qui sont identiques et successifs, puis

- une détermination par le processeur de traitement du signal numérique d'une valeur d'un symbole associé audit tableau de coefficients à partir du nombre desdits résultats identiques et successifs compté par ledit circuit dédié.

Dans un mode de mise en oeuvre avantageux, la mise en oeuvre dudit circuit dédié comprend une mise en oeuvre d'un premier bloc du circuit dédié pour calculer une variable de comparaisons permettant de stocker les résultats desdites comparaison, le résultat de chaque comparaison correspondant à un bit de la variable de comparaisons.

De préférence, la mise en oeuvre du premier bloc est adaptée pour réaliser en parallèle au moins deux comparaisons à partir d'au moins deux coefficients successifs du tableau de coefficients avec l'intervalle de valeurs.

Avantageusement, la mise en oeuvre du premier bloc comprend une mise en oeuvre d'au moins deux branches parallèles adaptées pour effectuer simultanément lesdites deux comparaisons, la mise en oeuvre de chaque branche comportant :

- la mise en oeuvre d'un circuit multiplieur pour effectuer une multiplication entre un coefficient parmi lesdits deux coefficients successifs et une longueur dudit intervalle de valeurs décalée d'un nombre donné de bits, ce nombre donné de bits étant notamment compris entre 0 et un nombre de bits utilisés pour définir la longueur dudit intervalle,
- la mise en oeuvre d'un circuit de comparaison pour comparer un résultat de la multiplication à une valeur de début de l'intervalle de valeurs.

Dans un mode de mise en oeuvre avantageux, la mise en oeuvre du premier bloc comprend en outre une mise en oeuvre d'un circuit de mise à jour de la variable de comparaisons pour intégrer dans ladite variable de comparaisons les résultats de la comparaison effectuée par chaque circuit de comparaison.

De préférence, la mise en oeuvre du circuit dédié comprend également une mise en oeuvre d'un deuxième bloc pour exécuter une machine d'état adaptée pour compter les résultats identiques successifs stockés dans ladite variable de comparaisons en analysant les bits de ladite variable de comparaisons.

Avantageusement, les résultats de chaque comparaison effectuée par le premier bloc sont stockés progressivement à droite dans la variable de comparaisons. La machine d'état mise en oeuvre par le deuxième bloc est alors adaptée pour compter le nombre de résultats de comparaison identiques à partir des bits situés les plus à droite dans la variable de comparaisons.

En variante, les résultats de chaque comparaison effectuée par le premier bloc sont stockés progressivement à gauche dans la variable de comparaisons. La machine d'état mise en oeuvre par le deuxième bloc est alors adaptée pour compter le nombre de résultats de comparaison identiques à partir des bits situés les plus à gauche dans la variable de comparaisons.

Dans un mode de mise en oeuvre avantageux, l'exécution dudit programme d'ordinateur entraîne :

- une mise en oeuvre du premier bloc afin d'effectuer en parallèle une comparaison à partir de chaque coefficient dudit tableau de coefficient avec ledit intervalle, le résultat de chaque comparaison étant stocké dans la variable de comparaison, puis
- une mise en oeuvre du deuxième bloc, une fois l'ensemble des comparaisons effectuées, pour compter les résultats identiques successifs stockés dans ladite variable de comparaisons en analysant les bits de ladite variable de comparaisons, puis
- un calcul par le processeur de traitement du signal numérique d'une valeur du symbole associé audit tableau de coefficients à partir du nombre de résultats identiques successifs compté.

D'autres avantages et caractéristiques de l'invention apparaîtront à l'examen de la description détaillée de modes de réalisation, nullement limitatifs, et des dessins annexés sur lesquels :

[Fig 1]
[Fig 2]
[Fig 3]
[Fig 4]
[Fig 5]
[Fig 6]
[Fig 7]
[Fig 8]

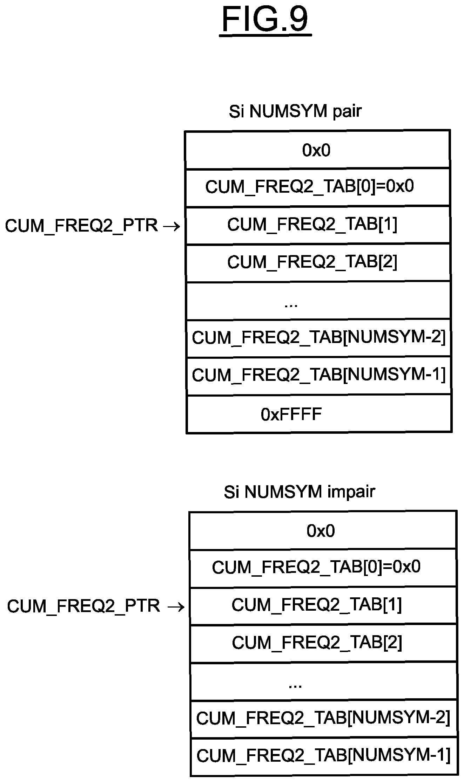

[Fig 9] illustrent des modes de réalisation et de mise en oeuvre de l'invention.

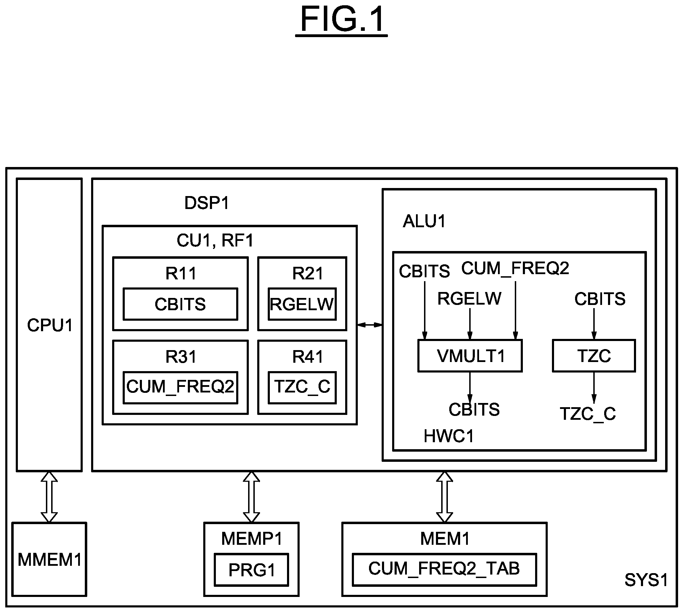

La figure 1 illustre un premier mode de réalisation d'un système informatique SYS1. Le système informatique SYS1 comprend une unité centrale de traitement CPU1 une mémoire principale MMEM1 et un processeur de traitement du signal numérique DSP1 (désigné également par l'expression anglaise « Digital signal processor ») avec une mémoire MEM1 de données et une mémoire MEMP1 de programme. Le DSP1 comprend une unité de control CU1 avec un banc de registres de données RF1 (désigné également par l'expression anglaise « Control Unit and Register File») et une unité arithmétique et logique ALU1 (désignée également par l'expression anglaise « Arithmetic and Logic Unit »). L'unité arithmétique et logique ALU1 comprend un circuit HWC1 dédié à l'accélération du décodage arithmétique. Le système informatique SYS1 peut être un système sur puce.

Le processeur de traitement du signal numérique DSP1 est configuré pour exécuter un programme d'ordinateur PRG1 comprenant des instructions permettant de réaliser un décodage arithmétique.

Ce programme d'ordinateur PRG1 peut être stocké dans la mémoire MEMP1 de programme du système informatique SYS1.

Le processeur de traitement du signal numérique DSP1 comprend un premier registre R11 configuré pour stocker une variable CBITS contenant les résultats de comparaisons.

Le processeur de traitement du signal numérique DSP1 comprend également un deuxième registre R21 configuré pour stocker une longueur RGE d'intervalle de valeurs et une valeur LW du début de cette intervalle de valeurs. La longueur RGE et la valeur LW peuvent être concaténées dans un même mot binaire RGELW dans le deuxième registre R21.

Le processeur de traitement du signal numérique DSP1 comprend également un troisième registre R31 configuré pour stocker deux coefficients concaténés.

Le processeur de traitement du signal numérique DSP1 comprend également un quatrième registre R41 configuré pour stocker un compteur TZC_C de bits à zéro à droite.

Le circuit HWC1 peut notamment être obtenu à partir d'un code « RTL » (de l'anglais « Register Transfer Level »)

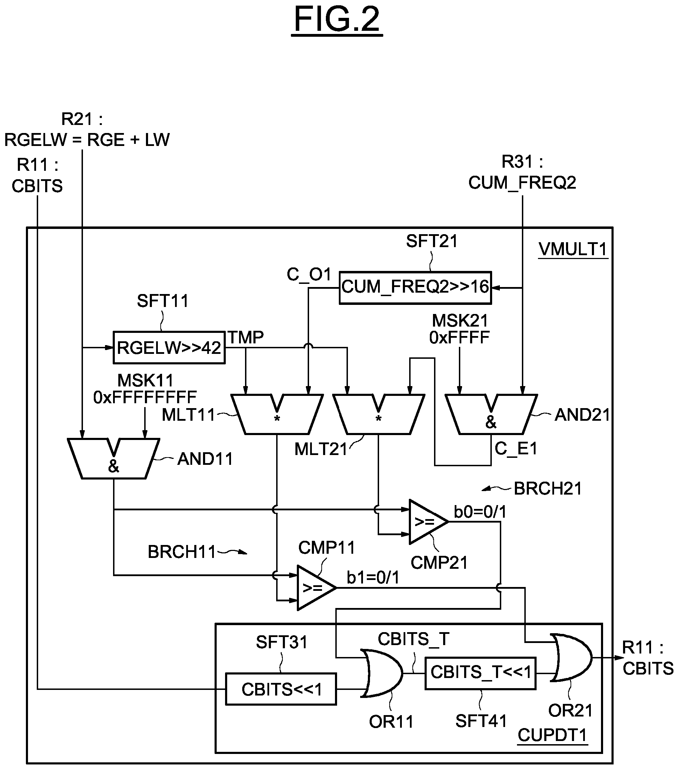

Le circuit HWC1 dédié comprend un premier bloc VMULT1 configuré pour effectuer des calculs et des tests de manière vectorielle (c'est-à-dire en parallèle) lors d'un décodage arithmétique. Ce premier bloc VMULT1 est illustré à la figure 2.

En particulier, le premier bloc VMULT1 est configuré pour recevoir en entrée la variable CBITS stockée dans le premier registre R11. Le premier bloc VMULT1 est aussi configuré pour recevoir en entrée le mot RGELW stockée dans le deuxième registre R21 comportant la longueur RGE d'intervalle et la valeur LW de début d'intervalle. La longueur RGE d'intervalle et la valeur LW peuvent être concaténées dans un même mot reçu en entrée. Le premier bloc VMULT1 est également configuré pour recevoir en entrée les deux coefficients concaténés CUM FREQ2.

Le premier bloc VMULT1 comprend un premier circuit de décalage SFT11. Ce premier circuit de décalage SFT11 est configuré pour recevoir le mot RGELW comprenant la longueur RGE d'intervalle et la valeur LW concaténé. Ce premier circuit de décalage est configuré pour décaler ce mot de 42 bits vers la droite. Cela permet de sortir les 32 bits associées à la valeur LW de début d'intervalle puis de décaler de 10 bits vers la droite la valeur de la longueur RGE d'intervalle afin d'obtenir une valeur temporaire TMP.

Le premier bloc VMULT1 comprend également une première porte logique AND11 de type « ET ». Cette première porte logique AND11 de type « ET » est configurée pour recevoir le mot RGELW comprenant la longueur RGE d'intervalle et la valeur LW concaténées ainsi qu'un premier masque MSK11 de valeur hexadécimale '0xFFFFFFFF'. Cette première porte logique AND11 de type « ET » permet d'appliquer le premier masque MSK11 sur ledit mot RGELW reçu en entrée de manière à récupérer la valeur LW de début d'intervalle.

Le premier bloc VMULT1 comprend également un deuxième circuit de décalage SFT21. Ce deuxième circuit de décalage SFT21 est configuré pour recevoir les deux coefficients concaténés CUM_FREQ2 et pour décaler ces deux coefficients concaténés CUM_FREQ2 de 16 bits vers la droite de manière à conserver uniquement le coefficient impair C_O1.

Le premier bloc VMULT1 comprend en outre une deuxième porte logique AND21 de type « ET ». Cette deuxième porte logique AND21 de type « ET » est configurée pour recevoir les deux coefficients concaténés CUM_FREQ2 ainsi qu'un deuxième masque MSK21 de valeur hexadécimale '0xFFFF'. Cette deuxième porte logique AND21 de type « ET » permet d'appliquer le deuxième masque MSK21 sur ladite valeur CIM_FREQ2 de manière à récupérer le coefficient pair C_E1.

Le premier bloc VMULT1 comprend également deux branches parallèles BRCH11, BRCH21. Une première branche BRCH11 comprend un premier circuit multiplieur MLT11 et un premier circuit de comparaison CMP11. La deuxième branche BRCH21 comprend un deuxième circuit multiplieur MLT21 et un deuxième circuit de comparaison CMP21. Les deux branches BRCH11, BRCH21 permettent d'effectuer en parallèle deux multiplications puis deux tests de comparaison à partir des deux coefficients différents C_O1 et C_E1 issus desdits deux coefficients concaténés CUM_FREQ2.

En particulier, le premier circuit multiplieur MLT11 est configuré pour recevoir en entrée la valeur temporaire TMP générée en sortie du premier circuit de décalage SFT11 et le coefficient impair C_O1. Le premier circuit multiplieur MLT11 est alors configuré pour multiplier ladite valeur temporaire TMP avec le coefficient impair C_O1.

Le deuxième circuit multiplieur MLT21 est configuré pour recevoir en entrée la valeur temporaire TMP générée en sortie du premier circuit de décalage SFT11 et le coefficient pair C_E1. Le deuxième circuit multiplieur MLT21 est alors configuré pour multiplier ladite valeur temporaire TMP avec le coefficient pair C_E1.

Le premier circuit de comparaison CMP11 est configuré pour recevoir le résultat de la multiplication réalisée par le premier circuit de multiplication MLT11 ainsi que la valeur LW de début d'intervalle. Le premier circuit de comparaison CMP11 est alors configuré pour comparer le résultat de ladite multiplication à la valeur LW de début d'intervalle afin de savoir si ladite valeur LW de début d'intervalle est supérieure ou égale au résultat de ladite multiplication. Si ladite valeur LW est supérieure ou égale au résultat de ladite multiplication, alors le premier circuit de comparaison CMP11 génère un bit de comparaison b1 égale à 1. Si ladite valeur LW est inférieure au résultat de ladite multiplication, alors le premier circuit de comparaison CMP11 génère un bit de comparaison b1 égale à 0.

Le deuxième circuit de comparaison CMP21 est configuré pour recevoir le résultat de la multiplication réalisée par le deuxième circuit de multiplication MLT21 ainsi que la valeur LW de début d'intervalle. Le deuxième circuit de comparaison CMP21 est alors configuré pour comparer le résultat de ladite multiplication à la valeur LW de début d'intervalle afin de savoir si ladite valeur LW de début d'intervalle est supérieure ou égale au résultat de ladite multiplication. Si ladite valeur LW est supérieure ou égale au résultat de ladite multiplication, alors le premier circuit de comparaison CMP21 génère un bit de comparaison b0 égale à 1. Si ladite valeur LW est inférieure au résultat de ladite multiplication, alors le premier circuit de comparaison CMP21 génère un bit de comparaison b0 égale à 0.

Le premier bloc VMULT1 comprend également un circuit CUPDT1 de mise à jour de la variable CBITS. Le circuit CUPDT1 de mise à jour de la variable CBITS permet d'intégrer les bits de comparaison b1 et b0 à droite de l'ancienne variable CBITS reçue en entrée du premier bloc VMULT1.

En particulier, le circuit CUPDT1 de mise à jour comprend un troisième circuit de décalage SFT31 configuré pour décaler d'un bit vers la gauche la variable CBITS reçue en entrée du premier bloc VMULT1.

Le circuit CUPDT1 de mise à jour comprend également une première porte logique OR11 de type « OU » configurée pour réaliser une opération de type « OU » entre la variable CBITS décalée d'un bit et le bit de comparaison b0. La première porte logique OR11 de type « OU » permet ainsi d'intégrer le bit de comparaison b0 dans la variable CBITS. Cela permet d'obtenir une variable CIBTS temporaire CBITS_T

Le circuit CUPDT1 de mise à jour comprend également un quatrième circuit de décalage SFT41 configuré pour décaler d'un bit vers la gauche la variable CBITS_T temporaire intégrant le bit de comparaison b0.

Le circuit CUPDT1 de mise à jour comprend également une deuxième porte logique OR21 de type « OU » configurée pour réaliser une opération de type « OU » entre le bit de comparaison b1 et la variable CBITS_T temporaire intégrant le bit de comparaison b0. La deuxième porte logique OR21 de type « OU » permet ainsi d'intégrer le bit de comparaison b1 dans la variable CBITS_T temporaire. Cela permet d'obtenir une variable CBITS mise à jour intégrant les bits de comparaison b0 et b1 à droite de la variable CBITS. La nouvelle variable CBITS peut ensuite être stockée dans le registre R11 du processeur de traitement du signal numérique DSP1.

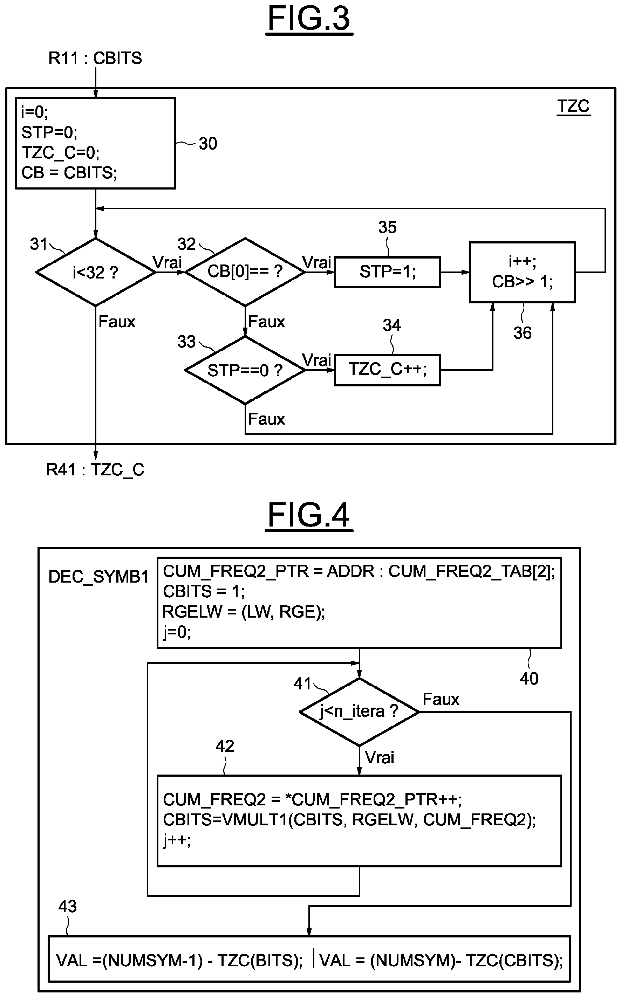

Le circuit HWC1 dédié comprend un deuxième bloc TZC configuré pour recevoir la variable CBITS stockée dans le premier registre R11. Le deuxième bloc TZC est configuré pour mettre en oeuvre une machine d'état permettant d'exécuter un procédé de comptage d'un nombre de bits à zéro à droite dans la variable CBITS. Un tel procédé est illustré à la figure 3.

Le procédé de comptage comprend une étape 30 d'initialisation. L'étape 30 d'initialisation permet d'initialiser un index i à 0, une variable d'arrêt STP à 0, un compteur de bits à zéro TZC_C à 0, et une variable CB à la valeur de la variable CBITS.

Le procédé de comptage comprend ensuite une première étape 31 de comparaison. Cette première étape 31 de comparaison est adaptée pour comparer si la valeur de l'index i est inférieure à 32.

Si la valeur de l'index i est inférieure à 32, alors le procédé comprend ensuite une deuxième étape 32 de comparaison. Cette deuxième étape 32 de comparaison est adaptée pour comparer si la valeur du bit de poids le plus faible CB[0] de la variable CB (c'est-à-dire le bit le plus à droite dans la variable CB) est égale à 1.

Si la valeur du bit de poids faible CB[0] de la variable CB est différente de 1, notamment égale à 0, alors le procédé comprend ensuite une troisième étape 33 de comparaison. Cette troisième étape 33 de comparaison est adaptée pour comparer si la variable d'arrêt STP est égale à 0.

Si la variable d'arrêt STP est égale à 0, alors le procédé comprend une étape 34 d'incrémentation du compteur de bits à zéro TZC_C.

Ensuite, le procédé comprend une étape 36 d'incrémentation de l'index i et de décalage de la variable CB. Dans cette étape 36, la valeur de l'index i est incrémentée de 1 et la variable CB est décalée vers la droite d'un bit.

Ensuite, le procédé est réitéré à partir de la première étape 31 de comparaison.

Si la valeur du bit de poids le plus faible CB[0] de la variable CB est égale à 1 à l'étape 32, alors le procédé comprend une étape 35 de mise à jour de la variable d'arrêt STP. Dans cette étape 35, la valeur d'arrêt STP est mise à 1. Ensuite, le procédé reprend à ladite étape 36 d'incrémentation de l'index i et de décalage de la variable CB.

Si la valeur de la variable d'arrêt STP est différente de 0, notamment égale à 1, à l'étape 33, alors le procédé reprend à l'étape 36 d'incrémentation de l'index i et de décalage de la variable CB.

Si la valeur de l'index i est égale à 32 à l'étape 31 alors la valeur du compteur de bits à zéro est écrite dans le registre R41.

Comme vu précédemment, le processeur de traitement du signal numérique DSP1 est configuré pour exécuter un programme d'ordinateur PRG1 comprenant des instructions qui permettent de réaliser un décodage arithmétique. En particulier, l'exécution desdites instructions conduisent le processeur de traitement du signal numérique DSP1 à exécuter une fonction DEC_SYMB1. Cette fonction DEC_SYMB1 est illustré à la figure 4.

Cette fonction DEC_SYMB1 est configurée pour déterminer la valeur d'un symbole à partir d'un tableau de coefficient CUM_FREQ2_TAB[] associé à ce symbole et stocké dans la mémoire MEM1 de données du processeur de traitement du signal numérique DSP1. Afin d'aligner chaque vecteur de deux éléments de 16-bit de ce tableau sur 32-bits, ce tableau est organisé selon la parité du nombre de symboles NUMSYM comme le montre Figure 9. Un élément zéro est inséré au début de chaque tableau. Quand NUMSYM est pair, un élément supplémentaire d'une valeur hexadécimal 0xFFFF est ajouté à la fin du tableau.

Plus particulièrement, le procédé de décodage comprend une étape 40 d'initialisation avant de déterminer la valeur du symbole à partir du tableau de coefficient CUM_FREQ2_TAB[].

Dans cette étape 40, le pointeur CUM_FREQ2_PTR est initialisé pour pointer vers l'adresse du tableau de coefficients CUM_FREQ2_TAB[2]. En outre, la variable CBITS est initialisée à 1. La longueur RGE de l'intervalle de valeurs et la valeur LW de début d'intervalle sont concaténées dans un même mot RGELW stocké dans le registre R11. Un index j est défini à 0.

Une fois l'initialisation terminée, la valeur du symbole peut être décodé par le procédé suivant.

Ledit procédé comprend une étape de test dans laquelle l'index j est comparé au nombre d'itérations n_itera à effectuer. En particulier, le nombre d'itérations n_itera à effectuer dépend du nombre de symboles possibles.

Si le nombre de symboles possibles est impair, alors le nombre d'itérations à effectuer est calculé par la formule suivante :

$$n\_itera = (NUMSYM - 1)/2,$$

où n_itera est le nombre d'itérations à effectuer et numsym est le nombre de symboles possibles.

Si le nombre de symboles possibles est pair, alors le nombre d'itérations à effectuer est calculé par la formule suivante :

$$n\_itera = NUMSYM/2,$$

où n_itera est le nombre d'itérations à effectuer et numsym est le nombre de symboles possibles.

Si l'index j est inférieur au nombre d'itérations n_itera à effectuer, alors le procédé comprend une étape 42 permettant d'effectuer en parallèle des multiplications et des comparaisons à partir de deux coefficients du tableau de coefficients.

L'étape 42 comprend une lecture d'une paire de coefficients puis une mise à jour du pointeur CUM_FREQ2_PTR afin de pointer vers le coefficient qui suit les deux coefficient lus.

L'étape 42 comprend ensuite un calcul d'une nouvelle valeur CBITS en mettant en oeuvre le premier bloc VMULT1 du circuit HWC1. En particulier, le premier bloc VMULT1 est mis en oeuvre en prenant en entrée la valeur CBITS actuelle, le mot RGELW et les deux coefficients CUM_FREQ2 précédemment lus.

La mise en oeuvre du premier bloc VMULT1 permet d'effectuer une multiplication entre les coefficients CUM_FREQ2 lus et la valeur RGE de la longueur de l'intervalle décalée de 10 bits vers la droite puis les comparaisons entre les résultats de ces multiplications et la valeur LW de début d'intervalle. Les résultats de ces comparaisons correspondent aux bits de comparaison b0 et b1 qui sont intégrés dans la nouvelle variable CBITS.

L'étape 42 comprend par la suite une incrémentation de l'index j de 1.

Ensuite, le procédé reprend à l'étape 41 de manière à réitérer les opérations mises en oeuvre par le premier bloc VMULT1 pour chaque coefficients du tableau CUM_FREQ[] jusqu'à ce que l'index j atteigne le nombre d'incrémentation à effectuer.

Lorsque l'index j atteint le nombre d'incrémentation à effectuer à l'étape 41, alors le procédé comprend une étape 43 de calcul de la valeur VAL. Cette valeur VAL est notamment calculée en mettant en oeuvre le deuxième bloc TZC afin de déterminer le nombre de zéros à droite dans la dernière variable CBITS calculée.

En particulier, si le nombre de symboles possibles est impair, alors la valeur du symbole est calculée par la formule :

$$VAL = (NUMSYM - 1) - TZC(CBITS),$$

où NUMSYM est un nombre pair de symboles possibles, TZC(CBITS) est la fonction mise en oeuvre par le deuxième bloc TZC à partir de la variable CBITS.

Si le nombre de symboles possibles est pair, alors la valeur du symbole est calculée par la formule :

$$VAL = NUMSYM - TZC(CBITS),$$

où NUMSYM est un nombre impair de symboles possibles, TZC(CBITS) est la fonction mise en oeuvre par le deuxième bloc TZC à partir de la variable CBITS.

Un symbole peut ensuite être décodé à partir de la valeur VAL calculé à partir de l'intervalle défini par la longueur RGE d'intervalle et de la valeur de début d'intervalle.

Dans un tel procédé de décodage arithmétique, le fait d'effectuer dans un premier temps l'ensemble des comparaisons associées à chacun des coefficients du tableau avant de calculer la valeur du symbole permet une parallélisation des comparaisons. Cela permet donc d'accélérer le décodage arithmétique.

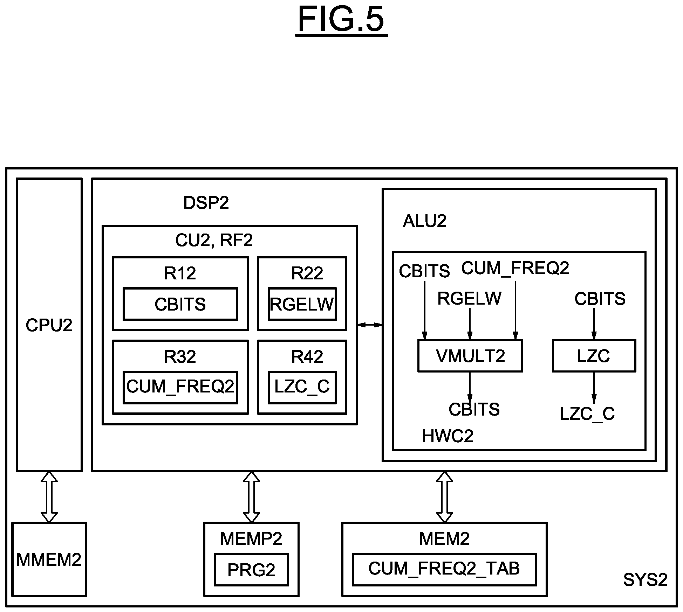

La figure 5 illustre un deuxième mode de réalisation d'un système informatique SYS2. Le système informatique SYS2 est similaire au système informatique SYS1 de la figure 1. En particulier, le système informatique SYS2 comprend une unité centrale de traitement CPU2, une mémoire principale MMEM2 et un processeur de traitement du signal numérique DSP2 (désigné également par l'expression anglaise « Digital signal processor ») avec une mémoire MEM2 de données, une mémoire MEMP2 de programme. Le processeur de traitement du signal numérique DSP2 comprend une unité de control CU2 avec un banc de registres de données RF2 (désigné également par l'expression anglaise « Control Unit and Register File») et une unité arithmétique et logique ALU2 (désignée également par l'expression anglaise « Arithmetic and Logic Unit »). L'unité arithmétique et logique ALU2 comprend un circuit HWC2 dédié à l'accélération du décodage arithmétique est intégré. Le système informatique SYS2 peut être un système sur puce.

Le processeur du signal numérique DSP2 est configuré pour exécuter un programme d'ordinateur PRG2 comprenant des instructions permettant de réaliser un décodage arithmétique Ce programme d'ordinateur PRG2 peut être stocké dans la mémoire MEMP2 de programme du système informatique SYS2.

Le processeur de traitement du signal numérique DSP2 comprend un premier registre R12 configuré pour stocker une variable CBITS de comparaisons.

Le processeur de traitement du signal numérique DSP2 comprend également un deuxième registre R22 configuré pour stocker une longueur RGE d'intervalle de valeurs et une valeur LW du début de cette intervalle de valeurs. La longueur RGE et la valeur LW peuvent être concaténées dans un même mot binaire RGELW dans le deuxième registre R22.

Le processeur de traitement du signal numérique DSP2 comprend également un troisième registre R32 configuré pour stocker deux coefficients concaténés CUM_FREQ2.

Le processeur de traitement du signal numérique DSP2 comprend également un quatrième registre R42 configuré pour stocker un compteur LZC_C de bits à zéro à gauche dans la variable CBITS.

Le circuit HWC2 peut notamment être intégré dans le processeur de traitement du signal numérique DSP2. Un tel circuit HWC2 peut notamment être obtenu à partir d'un code « RTL » (de l'anglais « Register Transfer Level »)

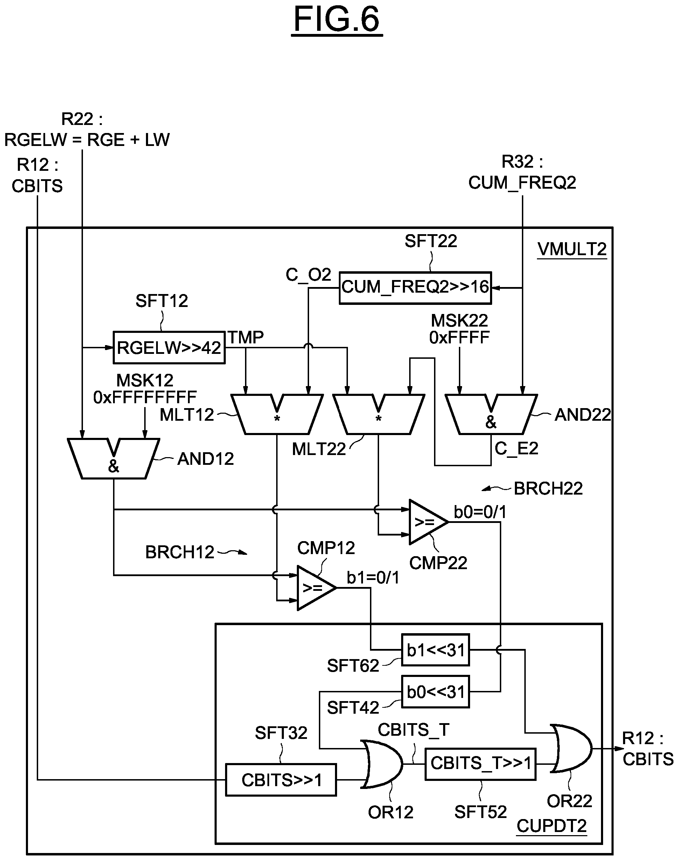

Le circuit HWC2 dédié comprend un premier bloc VMULT2 configuré pour effectuer des calculs et des tests de manière vectorielle (c'est-à-dire en parallèle) lors d'un décodage arithmétique. Ce premier bloc VMULT2 est illustré à la figure 6.

En particulier, le premier bloc VMULT2 est configuré pour recevoir en entrée la variable CBITS stockée dans le premier registre R12. Le premier bloc VMULT2 est aussi configuré pour recevoir en entrée la longueur RGE d'intervalle de valeurs et la valeur LW de début d'intervalle. La longueur RGE d'intervalle et la valeur LW peuvent être concaténées dans un même mot RGELW stocké dans le registre R22. Le premier bloc VMULT2 est également configuré pour recevoir en entrée les deux coefficients concaténés CUM FREQ2.

Le premier bloc VMULT2 comprend un premier circuit de décalage SFT12. Ce premier circuit de décalage SFT12 est configuré pour recevoir le mot RGELW comprenant la longueur RGE d'intervalle et la valeur LW concaténé. Ce premier circuit de décalage SFT12 est configuré pour décaler ce mot de 42 bits vers la droite. Cela permet de sortir les 32 bits associées à la valeur LW de début d'intervalle puis de décaler de 10 bits vers la droite la valeur de la longueur RGE d'intervalle afin d'obtenir une valeur temporaire TMP.

Le premier bloc VMULT2 comprend également une première porte logique AND12 de type « ET ». Cette première porte logique AND12 de type « ET » est configurée pour recevoir le mot RGELW comprenant la longueur RGE d'intervalle et la valeur LW concaténé ainsi qu'un premier masque MSK12 de valeur hexadécimale '0xFFFFFFFF'. Cette première porte logique AND12 de type « ET » permet d'appliquer le premier masque MSK12 sur ledit mot RGELW reçu en entrée de manière à récupérer la valeur LW de début d'intervalle.

Le premier bloc VMULT2 comprend également un deuxième circuit de décalage SFT22. Ce deuxième circuit de décalage SFT22 est configuré pour recevoir les deux coefficients concaténés CUM_FREQ2 et pour décaler ces deux coefficients concaténés CUM_FREQ2 de 16 bits vers la droite de manière à conserver uniquement le coefficient impair C_O2 desdits deux coefficients concaténés CUM_FREQ2.

Le premier bloc VMULT2 comprend en outre une deuxième porte logique AND22 de type « ET ». Cette deuxième porte logique AND22 de type « ET » est configurée pour recevoir les deux coefficients concaténés CUM_FREQ2 ainsi qu'un deuxième masque de valeur hexadécimale '0xFFFF'. Cette deuxième porte logique AND22 de type « ET » permet d'appliquer le deuxième masque sur les deux coefficients concaténés CUM_FREQ2 de manière à récupérer le coefficient pair C_E2 desdits deux coefficients concaténés CUM_FREQ2.

Le premier bloc VMULT2 comprend également deux branches parallèles BRCH12 et BRCH22. Une première branche BRCH12 comprend un premier circuit multiplieur MLT12 et un premier circuit de comparaison CMP12. La deuxième branche BRCH22 comprend un deuxième circuit multiplieur MLT22 et un deuxième circuit de comparaison CMP22. Les deux branches BRCH12 et BRCH22 permettent d'effectuer en parallèle deux multiplications puis deux tests de comparaison à partir des deux coefficients différents C_O2, C_E2 issus des deux coefficients concaténés CUM_FREQ2.

En particulier, le premier circuit multiplieur MLT12 est configuré pour recevoir en entrée la valeur temporaire TMP générée en sortie du premier circuit de décalage SFT12 et le coefficient impair C_O2. Le premier circuit multiplieur MLT12 est alors configuré pour multiplier ladite valeur temporaire TMP avec le coefficient impair C_O2.

Le deuxième circuit multiplieur MLT22 est configuré pour recevoir en entrée la valeur temporaire TMP générée en sortie du premier circuit de décalage SFT12 et le coefficient pair C_E2. Le deuxième circuit multiplieur MLT22 est alors configuré pour multiplier ladite valeur temporaire TMP avec le coefficient pair C_E2.

Le premier circuit de comparaison CMP12 est configuré pour recevoir le résultat de la multiplication réalisée par le premier circuit de multiplication MLT12 ainsi que la valeur LW de début d'intervalle. Le premier circuit de comparaison CMP12 est alors configuré pour comparer le résultat de ladite multiplication à la valeur LW de début d'intervalle afin de savoir si ladite valeur LW de début d'intervalle est supérieure ou égale au résultat de ladite multiplication. Si ladite valeur LW est supérieure ou égale au résultat de ladite multiplication, alors le premier circuit de comparaison CMP12 génère un bit de comparaison b1 égale à 1. Si ladite valeur LW est inférieure au résultat de ladite multiplication, alors le premier circuit de comparaison CMP12 génère un bit de comparaison b1 égale à 0.

Le deuxième circuit de comparaison CMP22 est configuré pour recevoir le résultat de la multiplication réalisée par le deuxième circuit de multiplication MLT22 ainsi que la valeur LW de début d'intervalle. Le deuxième circuit de comparaison CMP22 est alors configuré pour comparer le résultat de ladite multiplication à la valeur LW de début d'intervalle afin de savoir si ladite valeur LW de début d'intervalle est supérieure ou égale au résultat de ladite multiplication. Si ladite valeur LW est supérieure ou égale au résultat de ladite multiplication, alors le premier circuit de comparaison CMP22 génère un bit de comparaison b1 égale à 1. Si ladite valeur LW est inférieure au résultat de ladite multiplication, alors le premier circuit de comparaison CMP22 génère un bit de comparaison b1 égale à 0.

Le premier bloc VMULT2 comprend également un circuit CUPDT2 de mise à jour de la variable CBITS. Le circuit CUPDT2 de mise à jour de la variable CBITS permet d'intégrer les bits de comparaison b1 et b0 à droite de l'ancienne variable CBITS reçue en entrée du premier bloc VMULT2.

En particulier, le circuit CUPDT2 de mise à jour comprend un troisième circuit de décalage SFT32 configuré pour décaler d'un bit vers la droite la variable CBITS reçue en entrée.

Le circuit CUPDT2 de mise à jour comprend un quatrième circuit de décalage SFT42 configuré pour décaler de 31 bits vers la gauche le bit de comparaison b0.

Le circuit CUPDT2 de mise à jour comprend également une première porte logique OR12 de type « OU » configurée pour réaliser une opération de type « OU » entre la variable CBITS décalée d'un bit et le bit de comparaison b0 décalé. La première porte logique OR12 de type « OU » permet ainsi d'intégrer le bit de comparaison b0 à gauche dans la variable CBITS. Cela permet d'obtenir une variable CBITS_T temporaire.

Le circuit CUPDT2 de mise à jour comprend également un cinquième circuit de décalage SFT52 configuré pour décaler d'un bit vers la droite la variable CBITS_T temporaire intégrant le bit de comparaison b0.

Le circuit CUPDT2 de mise à jour comprend un sixième circuit de décalage SFT62 configuré pour décaler de 31 bits vers la gauche le bit de comparaison b1.

Le circuit CUPDT2 de mise à jour comprend également une deuxième porte logique OR22 de type « OU » configurée pour réaliser une opération de type « OU » entre le bit de comparaison b1 décalé et la variable CBITS_T temporaire intégrant le bit de comparaison b0 décalé d'un bit vers la droite. La deuxième porte logique OR22 de type « OU » permet ainsi d'intégrer le bit de comparaison b1 à gauche dans la variable CBITS_T temporaire. Cela permet d'obtenir une variable CBITS mise à jour intégrant les bits de comparaison b0 et b1 à gauche de la variable CBITS. La nouvelle variable CBITS peut ensuite être stockée dans le registre R12 du processeur de traitement du signal numérique DSP2.

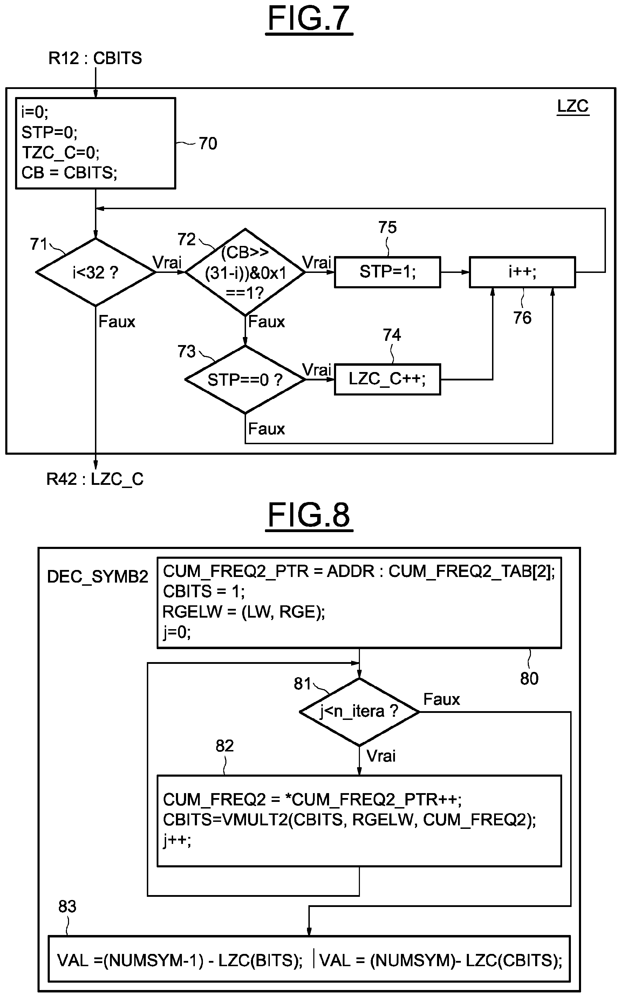

Le circuit HWC2 dédié comprend un deuxième bloc LZC configuré pour recevoir la variable CBITS stockée dans le premier registre R12. Le deuxième bloc LZC est configuré pour mettre en oeuvre une machine d'état permettant d'exécuter un procédé de comptage d'un nombre de zéros à gauche dans la variable CBITS. Un tel procédé de comptage est illustré à la figure 7.

Le procédé de comptage comprend une étape 70 d'initialisation. L'étape 70 d'initialisation permet d'initialiser un index i à 0, une variable d'arrêt STP à 0, un compteur LZC_C de bits à zéro à gauche à 0, et une variable CB à la valeur de la variable CBITS.

Le procédé de comptage comprend ensuite une première étape 71 de comparaison. Cette première étape 71 de comparaison est adaptée pour comparer si la valeur de l'index i est inférieure à 32.

Si la valeur de l'index est inférieure à 32, alors le procédé comprend ensuite une deuxième étape 72 de comparaison. Cette deuxième étape 72 de comparaison est adaptée pour décaler le variable CB d'un nombre de bits égal à 31-i puis appliquer un masque de valeur hexadécimale 0x1 à ladite variable CB décalée. La deuxième étape 72 de comparaison est également adaptée pour comparer ensuite si la valeur obtenue après l'application du masque sur la variable CB décalée est égale à 1.

Si la valeur obtenue après l'application du masque sur la variable CB décalée est différente de 1, notamment égale à 0, alors le procédé comprend ensuite une troisième étape 73 de comparaison. Cette troisième étape 73 de comparaison est adaptée pour comparer si la variable d'arrêt STP est égale à 0.

Si la variable d'arrêt STP est égale à 0, alors le procédé comprend une étape 74 d'incrémentation du compteur LZC_C de bits à zéro à gauche.

Ensuite, le procédé comprend une étape 76 d'incrémentation de l'index i. Dans cette étape, la valeur de l'index i est incrémentée de 1.

Ensuite, le procédé est réitéré à partir de la première étape 71 de comparaison.

Si la valeur obtenue après application du masque sur la variable CB décalée est égale à 1 à l'étape 72, alors le procédé comprend une étape 75 de mise à jour de la variable d'arrêt STP. Dans cette étape 75, la valeur d'arrêt STP est mise à 1. Ensuite, le procédé reprend à ladite étape 76 d'incrémentation de l'index i.

Si la valeur de la variable d'arrêt STP est différente de 0, notamment égale à 1, à l'étape 73, alors le procédé reprend à l'étape 76 d'incrémentation de l'index i.

Si la valeur de l'index i est égale à 32 à l'étape 71 alors la valeur du compteur de bits à zéro à gauche LZC_C est stockée dans le registre R42.

Comme vu précédemment, le processeur de traitement du signal numérique DSP2 est configurée pour exécuter un programme d'ordinateur PRG2 comprenant des instructions qui permettent de réaliser un décodage arithmétique. En particulier, l'exécution desdites instructions conduisent le processeur de traitement du signal numérique DSP2 à exécuter une fonction DEC_SYMB2. Cette fonction DEC_SYMB2 est illustrée à la figure 8.

Cette fonction DEC_SYMB2 est configurée pour déterminer la valeur d'un symbole à partir d'un tableau de coefficient CUM_FREQ2_TAB[] associé à ce symbole et stocké dans la mémoire MEM2 de données du processeur de traitement du signal numérique DSP2. Afin d'aligner chaque vecteur de 2 éléments de 16-bit de ce tableau sur 32-bit, ce tableau est organisé selon la parité du nombre de symboles NUMSYM comme le montre la figure 9. Un élément zéro est inséré au début de chaque tableau. Quand NUMSYM est pair, un élément supplémentaire d'une valeur hexadécimal 0xFFFF est ajouté à la fin du tableau.

Plus particulièrement, le procédé de décodage comprend une étape 80 d'initialisation avant de déterminer la valeur du symbole à partir du tableau de coefficient CUM_FREQ2_TAB[].

Dans cette étape 80, le pointeur CUM_FREQ2_PTR est initialisé pour pointer vers l'adresse du tableau de coefficients CUM_FREQ2_TAB[2]. En outre, la variable CBITS est initialisée à 1. La longueur RGE de l'intervalle de valeurs et la valeur LW de début d'intervalle sont concaténées dans un même mot RGELW. Un index j est défini à 0.

Une fois l'initialisation terminée, le symbole peut être décodé par le procédé suivant.

Le procédé comprend une étape 81 de test dans laquelle l'index j est comparé au nombre d'itérations n_itera à effectuer. En particulier, le nombre d'itérations n_itera à effectuer dépend du nombre de symboles possibles.

Si le nombre de symboles possibles est impair, alors le nombre d'itérations à effectuer est calculé par la formule suivante :

$$n\_itera = (numsym - 1)/2,$$

où n_itera est le nombre d'itérations à effectuer et numsym est le nombre de symboles possibles.

Si le nombre de symboles possibles est pair, alors le nombre d'itérations à effectuer est calculé par la formule suivante :

$$n\_itera = numsym/2,$$

où n_itera est le nombre d'itérations à effectuer et numsym est le nombre de symboles possibles.

Si l'index j est inférieur au nombre d'itérations à effectuer, alors le procédé comprend une étape 82 permettant d'effectuer en parallèle des multiplications et des comparaisons à partir de deux coefficients du tableau de coefficients.

L'étape 82 comprend une mise à jour du pointeur CUM_FREQ2_PTR afin de pointer vers le coefficient qui suit les deux coefficient lus.

L'étape 82 comprend ensuite un calcul d'une nouvelle valeur CBITS en mettant en oeuvre le premier bloc VMULT2 du circuit HWC2. En particulier, le premier bloc est mis en oeuvre en prenant en entrée la valeur CBITS actuelle, le mot RGELW et les deux coefficients CUM_FREQ2 précédemment lus.

La mise en oeuvre du premier bloc VMULT2 permet d'effectuer une multiplication entre les coefficients lus et la valeur de la longueur de l'intervalle décalée de 10 bits vers la droite puis les comparaisons entre les résultats de ces multiplications et la valeur de début d'intervalle. Les résultats de ces comparaisons correspondent aux bits de comparaison b0 et b1 qui sont intégrés dans la nouvelle variable CBITS.

L'étape 82 comprend par la suite une étape d'incrémentation de l'index j. Dans cette étape, l'index j est incrémenté de 1.

Ensuite, le procédé reprend à l'étape 81 de manière à réitérer les opérations mises en oeuvre par le premier bloc VMULT2 pour chaque coefficients du tableau CUM_FREQ[] jusqu'à ce que l'index j atteigne le nombre d'incrémentation à effectuer.

Lorsque l'index j atteint le nombre d'incrémentation à effectuer à l'étape 81, alors le procédé comprend une étape 83 de calcul de la valeur VAL. Cette valeur VAL est notamment calculée en mettant en oeuvre le deuxième bloc LZC afin de déterminer le nombre de zéros à droite dans la dernière variable CBITS calculée.

En particulier, si le nombre de symboles possibles est impair, alors la valeur du symbole est calculée par la formule :

$$VAL = (NUMSYM - 1) - LZC(CBITS),$$

où NUMSYM est un nombre pair de symboles possibles, LZC(CBITS) est la fonction mise en oeuvre par le deuxième bloc LZC à partir de la variable CBITS.

Si le nombre de symboles possibles est pair, alors la valeur du symbole est calculée par la formule :

$$VAL = NUMSYM - LZC(CBITS),$$

où NUMSYM est un nombre impair de symboles possibles, LZC(CBITS) est la fonction mise en oeuvre par le deuxième bloc LZC à partir de la variable CBITS.

Un symbole peut ensuite être décodé à partir de la valeur VAL calculé à partir de l'intervalle défini par la longueur RGE d'intervalle et de la valeur de début d'intervalle.

Dans un tel procédé de décodage arithmétique, le fait d'effectuer dans un premier temps l'ensemble des comparaisons associées à chacun des coefficients du tableau avant de calculer la valeur du symbole permet une parallélisation des comparaisons. Cela permet donc d'accélérer le décodage arithmétique.

Bien entendu, les modes de réalisation sont susceptibles de diverses variantes et modifications qui apparaîtront à l'homme de l'art. En particulier, il est possible que le processeur de traitement du signal numérique DSP2 soit configurée pour mettre en oeuvre elle-même la fonction réalisée par le deuxième bloc LZC. Ainsi, dans ce cas il n'est pas nécessaire de prévoir un tel deuxième bloc dans le circuit dédié. Cela permet alors un gain d'espace dans le système informatique SYS2.

En outre, les premiers blocs VMULT1 et VMULT2 peuvent présenter respectivement plus branches que les deux branches BRCH11, BRCH21 et BRCH12, BRCH22 afin d'effectuer un plus grand nombre de multiplications et de comparaisons à la fois afin de traiter plus rapidement l'ensemble des coefficients du tableau de coefficients CUM_FREQ2_TAB[].

Les procédés de décodage arithmétique précédemment décrits peuvent être mis en oeuvre dans le cadre d'un décodage d'un signal audio, normalement pour un décodeur LC3. Les symboles à décoder correspondent alors à des données audio.

## Revendications

**1.** Système informatique comprenant :

- une mémoire (MEM) de données configurée pour stocker un tableau de coefficients (CUM_FREQ2_TAB[]),
- un processeur du traitement du signal numérique (DSP1, DSP2) configuré pour exécuter un programme d'ordinateur (PRG1, PRG2) comprenant des instructions permettant de réaliser un décodage arithmétique à partir dudit tableau de coefficients et d'un intervalle de valeurs,
- un circuit (HWC1, HWC2) dédié audit décodage arithmétique, ce circuit étant configuré pour :

    • effectuer des comparaisons à partir des coefficients dudit tableau de coefficients et dudit intervalle de valeurs, puis
    • compter les résultats desdites comparaisons qui sont identiques et successifs,

le processeur de traitement du signal numérique (DSP1, DSP2) étant configurée pour déterminer une valeur d'un symbole associé audit tableau de coefficients à partir du nombre desdits résultats identiques et successifs compté par ledit circuit dédié.

**2.** Système selon la revendication 1, dans lequel le circuit (HCW1, HCW2) dédié comprend un premier bloc (VMULT1, VMULT2) configuré pour calculer une variable (CBITS) de comparaisons permettant de stocker les résultats desdites comparaison, le résultat de chaque comparaison correspondant à un bit de la variable (CBITS) de comparaisons.

**3.** Système selon la revendication 2, dans lequel le premier bloc (VMULT1, VMULT2) est configuré pour réaliser en parallèle au moins deux comparaisons à partir d'au moins deux coefficients (C_O1, C_E1, C_O2, C_E2) successifs du tableau de coefficients avec l'intervalle de valeurs.

**4.** Système selon la revendication 3, dans lequel le premier bloc (VMULT1, VMULT2) comprend au moins deux branches parallèles (BRCH11, BRCH21, BRCH12, BRCH22) permettant d'effectuer simultanément lesdites deux comparaisons, chaque branche comportant :

    • un circuit multiplieur (MLT11, MLT21, MLT12, MLT22) configuré pour effectuer une multiplication entre un coefficient parmi lesdits deux coefficients (C_O1, C_E1, C_O2, C_E2) successifs et une longueur (RGE) dudit intervalle de valeurs décalée d'un nombre donné de bits, ce nombre donné de bits étant notamment compris entre 0 et un nombre de bits utilisés pour définir la longueur dudit intervalle,
    • un circuit de comparaison (CMP11, CMP21, CMP12, CMP22) configuré pour comparer un résultat de la multiplication à une valeur de début (LW) de l'intervalle de valeurs.

**5.** Système selon la revendication 4, dans lequel le premier bloc comprend en outre un circuit (CUPDT1, CUPDT2) de mise à jour de la variable de comparaisons configuré pour intégrer dans ladite variable de (CBITS) comparaisons les résultats de la comparaison effectuée par chaque circuit de comparaison.

**6.** Système selon l'une des revendications 2 à 5, dans lequel le circuit (HCW1, HCW2) dédié comprend également un deuxième bloc (TZC, LZC) configuré pour mettre en oeuvre une machine d'état configuré pour compter les résultats identiques successifs stockés dans ladite variable (CBITS) de comparaisons en analysant les bits de ladite variable (CBITS) de comparaisons.

**7.** Système selon la revendication 6, dans lequel les résultats de chaque comparaison effectuée par le premier bloc (VMULT1) sont stockés progressivement à droite dans la variable (CBITS) de comparaisons, et dans lequel la machine d'état mise en oeuvre par le deuxième bloc (TZC) est configurée pour compter le nombre de résultats de comparaison identiques à partir des bits situés les plus à droite dans la variable (CBITS) de comparaisons.

8. Système selon la revendication 6, dans lequel les résultats de chaque comparaison effectuée par le premier bloc (VMULT2) sont stockés progressivement à gauche dans la variable (CBITS) de comparaisons, et dans lequel la machine d'état mise en oeuvre par le deuxième bloc (LZC) est configurée pour compter le nombre de résultats de comparaison identiques à partir des bits situés les plus à gauche dans la variable (CBITS) de comparaisons.

9. Système selon l'une des revendications 6 à 8, dans lequel ledit programme d'ordinateur (PRG1, PRG2) comprend des instructions qui lorsqu'elles sont exécutées par le processeur de traitement du signal numérique (DSP1, DSP2) conduisent celui-ci à :

   - mettre en oeuvre le premier bloc (VMULT1, VMULT2) afin d'effectuer en parallèle une comparaison à partir de chaque coefficient dudit tableau de coefficient avec ledit intervalle, le résultat de chaque comparaison étant stocké dans la variable (CBITS) de comparaison, puis
   - mettre en oeuvre le deuxième bloc (TZC, LZC), une fois l'ensemble des comparaisons effectuées, pour compter les résultats identiques successifs stockés dans ladite variable (CBITS) de comparaisons en analysant les bits de ladite variable (CBITS) de comparaisons, puis
   - calculer une valeur (VAL) du symbole associé audit tableau de coefficients à partir du nombre de résultats identiques successifs compté.

10. Procédé mis en oeuvre par un système informatique (SYS1, SYS2), le procédé comprenant une exécution, par un processeur de traitement du signal numérique (DSP1, DSP2) du système informatique (SYS1, SYS2), d'un programme d'ordinateur (PRG1, PRG2) comprenant des instructions permettant de réaliser un décodage arithmétique à partir d'un tableau de coefficients stocké dans une mémoire de données du système informatique (SYS1, SYS2) et d'un intervalle de valeurs, le décodage arithmétique comportant :

   - une mise en oeuvre d'un circuit (HWC1, HWC2) du système informatique dédié audit décodage arithmétique pour :

      • effectuer des comparaisons à partir des coefficients dudit tableau de coefficients et dudit intervalle de valeurs, puis
      • compter les résultats desdites comparaisons qui sont identiques et successifs, puis

   - une détermination par le processeur de traitement du signal numérique (DSP1, DSP2) d'une valeur d'un symbole associé audit tableau de coefficients à partir du nombre desdits résultats identiques et successifs compté par ledit circuit dédié.

11. Procédé selon la revendication 10, dans lequel la mise en oeuvre dudit circuit (HCW1, HCW2) dédié comprend une mise en oeuvre d'un premier bloc (VMULT1, VMULT2) du circuit dédié pour calculer une variable (CBITS) de comparaisons permettant de stocker les résultats desdites comparaison, le résultat de chaque comparaison correspondant à un bit de la variable (CBITS) de comparaisons.

12. Procédé selon la revendication 11, dans lequel la mise en oeuvre du premier bloc (VMULT1, VMULT2) est adaptée pour réaliser en parallèle au moins deux comparaisons à partir d'au moins deux coefficients (C_O1, C_E1, C_O2, C_E2) successifs du tableau de coefficients avec l'intervalle de valeurs.

13. Procédé selon la revendication 12, dans lequel la mise en oeuvre du premier bloc (VMULT1, VMULT2) comprend une mise en oeuvre d'au moins deux branches parallèles (BRCH11, BRCH21, BRCH12, BRCH22) adaptées pour effectuer simultanément lesdites deux comparaisons, la mise en oeuvre de chaque branche comportant :

   • la mise en oeuvre d'un circuit multiplieur (MLT11, MLT21, MLT12, MLT22) pour effectuer une multiplication entre un coefficient parmi lesdits deux coefficients (C_O1, C_E1, C_O2, C_E2) successifs et une longueur (RGE) dudit intervalle de valeurs décalée d'un nombre donné de bits, ce nombre donné de bits étant notamment compris entre 0 et un nombre de bits utilisés pour définir la longueur dudit intervalle,
   • la mise en oeuvre d'un circuit de comparaison (CMP11, CMP21, CMP12, CMP22) pour comparer un résultat de la multiplication à une valeur de début (LW) de l'intervalle de valeurs.

14. Procédé selon la revendication 13, dans lequel la mise en oeuvre du premier bloc (VMULT1, VMULT2) comprend en outre une mise en oeuvre d'un circuit (CUPDT1, CUPDT2) de mise à jour de la variable de comparaisons pour intégrer dans ladite variable de (CBITS) comparaisons les résultats de la comparaison effectuée par chaque circuit de comparaison.

15. Procédé selon l'une des revendications 11 à 14, dans lequel la mise en oeuvre du circuit (HCW1, HCW2) dédié comprend également une mise en oeuvre d'un deuxième bloc (TZC, LZC) pour exécuter une machine d'état adaptée pour compter les résultats identiques successifs stockés dans ladite variable (CBITS) de comparaisons en analysant les bits de ladite variable (CBITS) de comparaisons.

16. Procédé selon la revendication 15, dans lequel les résultats de chaque comparaison effectuée par le premier bloc (VMULT1) sont stockés progressivement à droite dans la variable (CBITS) de comparaisons, et dans lequel la machine d'état mise en oeuvre par le deuxième bloc (TZC) est adaptée pour compter le nombre de résultats de comparaison identiques à partir des bits situés les plus à droite dans la variable (CBITS) de comparaisons.

17. Procédé selon la revendication 15, dans lequel les résultats de chaque comparaison effectuée par le premier bloc (VMULT2) sont stockés progressivement à gauche dans la variable (CBITS) de comparaisons, et dans lequel la machine d'état mise en oeuvre par le deuxième bloc (LZC) est adaptée pour compter le nombre de résultats de comparaison identiques à partir des bits situés les plus à gauche dans la variable (CBITS) de comparaisons.

18. Procédé selon l'une des revendications 15 à 17, dans lequel l'exécution dudit programme d'ordinateur entraîne :

  - une mise en oeuvre du premier bloc (VMULT1, VMULT2) afin d'effectuer en parallèle une comparaison à partir de chaque coefficient dudit tableau de coefficient avec ledit intervalle, le résultat de chaque comparaison étant stocké dans la variable (CBITS) de comparaison, puis
  - une mise en oeuvre du deuxième bloc (TZC, LZC), une fois l'ensemble des comparaisons effectuées, pour compter les résultats identiques successifs stockés dans ladite variable (CBITS) de comparaisons en analysant les bits de ladite variable (CBITS) de comparaisons, puis
  - un calcul par le processeur de traitement du signal numérique (DSP1, DSP2) d'une valeur (VAL) du symbole associé audit tableau de coefficients à partir du nombre de résultats identiques successifs compté.

# FIG.1

# FIG.2

# FIG.3

R11 : CBITS

```
i=0;
STP=0;          30
TZC_C=0;
CB = CBITS;
```

TZC

31  i<32 ?   Vrai   32  CB[0]== ?   Vrai   35  STP=1;   →   i++;   CB>> 1;   36

Faux   Faux

33  STP==0 ?   Vrai   34  TZC_C++;

Faux

R41 : TZC_C

# FIG.4

DEC_SYMB1

```
CUM_FREQ2_PTR = ADDR : CUM_FREQ2_TAB[2];
CBITS = 1;
RGELW = (LW, RGE);
j=0;
```
40

41  j<n_itera ?   Faux

Vrai

42
```
CUM_FREQ2 = *CUM_FREQ2_PTR++;
CBITS=VMULT1(CBITS, RGELW, CUM_FREQ2);
j++;
```

43  VAL =(NUMSYM-1) - TZC(BITS);  | VAL = (NUMSYM)- TZC(CBITS);

# FIG.5

# FIG.6

# FIG.7

R12 : CBITS

```
i=0;
STP=0;          ~70
TZC_C=0;
CB = CBITS;
```

LZC

71 — i<32 ?

Vrai → 72 — (CB>> (31-i))&0x1 ==1?

Vrai → 75 — STP=1;

→ i++;   76

Faux (from 71)

Faux (from 72) → 73 — STP==0 ?

Vrai → 74 — LZC_C++;

Faux (from 73)

R42 : LZC_C

# FIG.8

DEC_SYMB2

```
CUM_FREQ2_PTR = ADDR : CUM_FREQ2_TAB[2];
CBITS = 1;
RGELW = (LW, RGE);
j=0;
```
80

81 — j<n_itera ?   Faux

Vrai

82
```
CUM_FREQ2 = *CUM_FREQ2_PTR++;
CBITS=VMULT2(CBITS, RGELW, CUM_FREQ2);
j++;
```

83
VAL =(NUMSYM-1) - LZC(BITS);  | VAL = (NUMSYM)- LZC(CBITS);

# FIG.9

Si NUMSYM pair

| |
|---|
| 0x0 |
| CUM_FREQ2_TAB[0]=0x0 |
| CUM_FREQ2_TAB[1] |
| CUM_FREQ2_TAB[2] |
| ... |
| CUM_FREQ2_TAB[NUMSYM-2] |
| CUM_FREQ2_TAB[NUMSYM-1] |
| 0xFFFF |

CUM_FREQ2_PTR → (points to CUM_FREQ2_TAB[1])

Si NUMSYM impair

| |
|---|
| 0x0 |
| CUM_FREQ2_TAB[0]=0x0 |
| CUM_FREQ2_TAB[1] |
| CUM_FREQ2_TAB[2] |
| ... |
| CUM_FREQ2_TAB[NUMSYM-2] |
| CUM_FREQ2_TAB[NUMSYM-1] |

CUM_FREQ2_PTR → (points to CUM_FREQ2_TAB[1])

Europäisches
Patentamt

European
Patent Office

Office européen
des brevets

## RAPPORT DE RECHERCHE EUROPEENNE

Numéro de la demande

EP 24 21 8047

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2017/074539 A1 (QUALCOMM INC [US]) 4 mai 2017 (2017-05-04) * alinéa [0006] - alinéa [0009]; revendications 1,2,6; figures 1,3, 4 * * alinéa [0023] * * alinéa [0033] - alinéa [0059] * * alinéa [0127] - alinéa [0130] * ----- | 1-18 | INV. H03M7/40 H03M7/30 |
| A | WO 2008/002804 A1 (INTEL CORP [US]; HAQUE MUNSI [US] ET AL.) 3 janvier 2008 (2008-01-03) * abrégé * * page 10, ligne 12 - page 18, ligne 18; figure 6 * ----- | 1-18 | |
| A | US 7 932 843 B2 (TEXAS INSTRUMENTS INC [US]) 26 avril 2011 (2011-04-26) * le document en entier * ----- | 1-18 | |

DOMAINES TECHNIQUES
RECHERCHES (IPC)

H03M
H04N
G06F

Le présent rapport a été établi pour toutes les revendications

| Lieu de la recherche | Date d'achèvement de la recherche | Examinateur |
|---|---|---|
| La Haye | 8 avril 2025 | Belardinelli, Carlo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................................................

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 21 8047

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-04-2025

| Document brevet cité au rapport de recherche | Date de publication | Membre(s) de la famille de brevet(s) | Date de publication |
|---|---|---|---|
| WO 2017074539 A1 | 04-05-2017 | CN 108353174 A | 31-07-2018 |
| | | EP 3369250 A1 | 05-09-2018 |
| | | JP 2018536344 A | 06-12-2018 |
| | | KR 20180075523 A | 04-07-2018 |
| | | TW 201724852 A | 01-07-2017 |
| | | US 2017127071 A1 | 04-05-2017 |
| | | WO 2017074539 A1 | 04-05-2017 |
| WO 2008002804 A1 | 03-01-2008 | CN 101480054 A | 08-07-2009 |
| | | GB 2450287 A | 17-12-2008 |
| | | US 7262722 B1 | 28-08-2007 |
| | | WO 2008002804 A1 | 03-01-2008 |
| US 7932843 B2 | 26-04-2011 | US 2010097248 A1 | 22-04-2010 |
| | | US 2010097250 A1 | 22-04-2010 |
| | | US 2010098155 A1 | 22-04-2010 |

EPO FORM P0460

Pour tout renseignement concernant cette annexe : voir Journal Officiel de l'Office européen des brevets, No.12/82